# EUROPEAN PATENT APPLICATION

(11) **EP 2 042 922 A2**
(43) Date of publication of application: **01.04.2009**
(21) Application number: 08165127.5
(22) Date of filing: 25.09.2008
(51) Int. Cl.: G03F 7/00, C23C 16/26, C23C 16/52

(54) **Cyclopentene as a precursor for carbon-based films**

(30) Priority: 27.09.2007 US 975683 P; 16.09.2008 US 211197
(71) Applicant: Air Products and Chemicals, Inc., Allentown, PA 18195-1501 (US)
(72) Inventor: Vrtis, Raymond Nicholas, Orefield, PA 18069 (US); Motika, Stephen Andrew, Kutztown, PA 19530 (US); Mayorga, Steven Gerard, Oceanside, CA 92056 (US)
(74) Representative: Schwabe - Sandmair - Marx

(57) **Abstract**

The present invention provides a method for forming an amorphous carbon layer on a substrate. The method comprises the steps of: positioning the substrate in a processing chamber; introducing a process gas into the processing chamber, wherein the process gas comprises a composition comprising a C₄ to C₁₀ cyclic hydrocarbon having a single carbon-carbon double band, wherein the composition is free of a stabilizer; generating a plasma of the process gas; and depositing an amorphous carbon layer on the substrate.

## Description

### BACKGROUND OF THE INVENTION

The present invention relates to chemical vapor deposition methods for forming an amorphous carbon film by employing a stable hydrocarbon compound as a precursor. More particularly, the present invention relates to utilizing cyclopentene as a precursor for depositing carbon films such as, for example, carbon hardmasks for use in semiconductor processing.

The fabrication of modern semiconductor devices requires the formation of metal and dielectric layers on a substrate by chemical reaction of gases, referred to as chemical vapor deposition ("CVD"). CVD processes supply reactive gases to the substrate surface where energy-induced chemical reactions take place to produce a desired layer.

CVD processes are useful in forming vertical and horizontal interconnects by a damascene or dual damascene method involving the deposition and patterning of one or more material layers. In the damascene method, one or more dielectric materials, such as the low k dielectric materials (i.e., having a dielectric constant (k)<4.0), are deposited and pattern etched to form the vertical interconnects, also known as vias, and horizontal interconnects, also known as lines. Conductive materials, such as those that contain copper, and other materials including barrier layer materials used to prevent diffusion of copper containing materials into the surrounding low k dielectric are then inlaid into the etched pattern. Any excess copper containing material and excess barrier layer material external to the etched pattern, such as on the field of the substrate, is then removed.

However, it has been difficult to produce features with little or no surface defects or feature deformation when low k materials have been used in damascene formation. Low k dielectric materials are often porous and susceptible to being scratched and damaged during removal of conductive materials, thus increasing the likelihood of defects being formed on the substrate surface. Further, low k materials are often brittle and may deform under conventional polishing processes. One solution to limiting or reducing surface defects and deformation is depositing a hardmask over the exposed low k materials prior to patterning and etching feature definitions in the low k materials. The hardmask resists damage and deformation. The hardmask may also protect the underlying low k materials during subsequent material deposition and planarization or material removal processes, such as chemical mechanical polishing techniques or etching techniques, thereby reducing defect formation and feature deformation. The hardmask may then be removed following planarization prior to subsequent processing of the substrate.

Additionally, in the damascene process described above, patterns are formed using conventional lithographic techniques in which a layer of energy sensitive resist is formed over a stack of material layers on a substrate and an image of a pattern is introduced into the energy sensitive resist material. Next, the pattern introduced into the energy sensitive resist material is transferred into one or more layers of the material stack formed on the substrate using the layer of energy sensitive resist as a mask.

The pattern introduced into the energy sensitive resist can be transferred into one or more layers of the material stack using a chemical etchant. The chemical etchant is designed to have a greater etch selectivity for the material layers of the stack than for the energy sensitive resist. That is, the chemical etchant etches the one or more layers of the material stack at a much faster rate than it etches the energy sensitive resist. The faster etch rate for the one or more material layers of the stack typically prevents the energy sensitive resist material from being consumed prior to completion of the pattern transfer.

As the pattern dimensions are reduced, the thickness of the energy sensitive resist must correspondingly be reduced in order to control pattern resolution. Such thinner resist materials (less than about 6000Ǻ) can be insufficient to mask underlying material layers during a pattern transfer step using a chemical etchant. A hardmask layer as described above may be used between the energy sensitive resist material and the underlying material layers to facilitate pattern transfer into the underlying material layers. In some applications for forming semiconductor structures, however, it is difficult to remove hardmask materials from the substrate surface and the remaining hardmask material may detrimentally affect semiconductor processing. Further, conventional hardmask materials may not provide sufficient etch selectivity between the material being etched and the hardmask to retain the desired dimensions of the features being formed.

Resist patterning problems are further compounded when lithographic imaging tools having deep ultraviolet ("DUV") imaging wavelengths (e. g., less than about 250 nanometers (nm)) are used to generate the resist patterns. The DUV imaging wavelengths improve resist pattern resolution because diffraction effects are reduced at these shorter wavelengths. The increased reflective nature of many underlying materials, such as polysilicon, metals, and metal silicides at such DUV wavelengths, however, can degrade the resulting resist patterns.

One technique proposed to minimize reflections from an underlying material layer uses an anti-reflective coating ("ARC"). The ARC is formed over the reflective material layer prior to resist patterning. The ARC suppresses the reflections off the underlying material layer during resist imaging, providing accurate pattern replication in the layer of energy sensitive resist. A number of ARC materials have been suggested for use in combination with energy sensitive resists but have had less than satisfactory results. Additionally, some current deposition processes for hardmasks and anti-reflective coating use processes and precursors that have less than desirable step-coverage. Further, ARC materials, like hardmask materials are difficult to remove and may leave residues behind that potentially interfere with subsequent integrated circuit fabrication steps.

CVD processes employed to prepare carbon hardmasks typically use precursors such as, for example, propylene, acetylene, and isoprene because it is generally believed that precursors which are highly unsaturated perform better. For example, propylene is generally considered to be more desirable than propane and isoprene is generally considered to be more desirable than isopentane.

Isoprene is a promising carbon hardmask precursor that has a high deposition rate, a relatively low etch rate in a CF₄/O₂ plasma, and has a high vapor pressure; however, there are several significant drawbacks associated with the use of isoprene. First, isoprene is a Class 1a flammable hazard which limits the amount which can be stored at a facility. Second, isoprene is a known carcinogen and mutagen and, thus, it is regarded as a health hazard. Third, isoprene is generally unstable and, thus, requires a inhibitor to prevent peroxide formation, an exothermic thermal decomposition pathway which may lead to a self accelerating polymerization, and isoprene is also susceptible to Diels-Alder dimerization upon standing at room temperature which results in a purity/ shelf-life issue.

The degradation of isoprene raises a number of issues for its application as a precursor for making carbon films. The high rate of degradation suggests that the chemical composition and physical properties of the precursor will change over time. Such changes are likely to have a significant impact on the properties of the resulting film, making it difficult for end users to produce a consistent quality film that conforms to the rigorous production specifications of thin film manufacturers.

A second problem posed by the isoprene degradation is related to the chemical delivery method commonly used for such liquid precursors. Volatile liquids such as isoprene are often delivered by a technique referred to in the industry as DLI, or direct liquid injection. For DLI systems the precursor is delivered to the tool at a precisely metered rate as a liquid through an injector port into the heated injection manifold. The manifold is operated at elevated temperature and reduced pressure to cause the precursor to rapidly vaporize. Once vaporized, the gaseous precursor is delivered to the deposition chamber. The DLI delivery method will indiscriminately transfer the isoprene liquid along with any dissolved oligomeric degradation products to the heated injector. The oligomers are expected to be either less volatile or non-volatile under the temperature and pressure conditions of the heated injection manifold. The delivery of low volatility oligomeric components would result in the gradual accumulation of such species in the tool plumbing which is expected to have a detrimental impact on tool operation and/or film quality. The vaporizers must be operated at temperatures below the boiling point of the liquids in order to prevent cavitation of the liquid and air bubble formation which would interfere with the liquid mass flow meter. The low temperatures that the isoprene DLI systems must be operated at will likely cause build-up of inhibitor in the injector due to the high boiling point of most inhibitors. This build-up will likely lead to injector or delivery line clogging.

The prior art discloses a variety of chemicals used to stabilize hydrocarbon-based porogens against the polymerization of olefinic hydrocarbons, including several broad classes of organic compounds such as phenols, amines, hydroxylamines, nitro compounds, quinine compounds and certain inorganic salts. Use of such stabilizers, however, will inherently reduce chemical purity, may themselves be deposited in the growing films and, as discussed above, may degrade the performance of liquid injectors due to their low volatility. Moreover, where a composition comprising a hydrocarbon and a stabilizer is introduced into a chamber either by vapor draw or by bubbling with a carrier gas, the stabilizer may crystallize as its concentration in the composition increases. Such phenomena may result in entrainment of such particles in the gas phase which is introduced into the chamber thereby causing particle defects on the wafer.

Therefore, a need exists in the art for a stable composition that is useful for depositing a carbon layer such as, for example, those useful for integrated circuit fabrication, that has good etch selectivity and/or anti-reflective properties and which may further be removed with little or minimal residues, and which will not degrade until the point of its intended use.

### BRIEF SUMMARY OF THE INVENTION

The present invention satisfies this need by providing a composition and method for forming an amorphous carbon layer on a substrate. In one aspect, the present invention provides a method for forming an amorphous carbon layer for use in integrated circuit fabrication. The amorphous carbon layer is formed by positioning the substrate in a processing chamber; introducing a process gas into the processing chamber, wherein the process gas comprises a composition comprising a C₄ to C₁₀ cyclic hydrocarbon having a single carbon-carbon double bond, wherein the composition is free of a stabilizer; generating a plasma of the process gas; and depositing an amorphous carbon layer on the substrate.

In another aspect, the present invention provides a method for forming an amorphous carbon layer for use in integrated circuit fabrication, the method comprising the steps of: positioning the substrate in a processing chamber; introducing a process gas into the processing chamber, wherein the process gas comprises a composition comprising cyclopentene, wherein the composition is free of a stabilizer; generating a plasma of the process gas; and depositing an amorphous carbon layer on the substrate.

In yet another aspect, the present invention provides a method for forming an amorphous carbon layer on a substrate, the method comprising the steps of: positioning the substrate in a processing chamber; vaporizing liquid cyclopentene from a vessel to form at least one component of a process gas; introducing the process gas into the processing chamber; generating a plasma of the process gas; and depositing an amorphous carbon layer on the substrate.

### BRIEF DESCRIPTION OF SEVERAL VIEWS OF THE DRAWINGS

The teachings of the present invention can be readily understood by considering the following detailed description in conjunction with the accompanying drawings, in which:

FIG. 1 is a schematic illustration of an exemplary apparatus that can be used for the practice of this invention;

FIG. 2 provides data comparing the thermal stability of cyclopentene and isoprene;

FIG. 3 provides stability data of isoprene; and

FIG. 4 provides stability data of cyclopentene.

### DETAILED DESCRIPTION OF THE INVENTION

The present invention is described in detail using preferred embodiments. The present invention, however, is not limited to these embodiments. Additionally, a requirement in an embodiment is freely applicable to other embodiments, and requirements are mutually replaceable unless special conditions are attached.

According to another embodiment, the present invention provides a method for forming an amorphous carbon layer for use in integrated circuit fabrication. The amorphous carbon layer is formed by positioning the substrate in a processing chamber; introducing a process gas into the processing chamber, wherein the process gas comprises a composition comprising a C₄ to C₁₀ cyclic hydrocarbon having a single carbon-carbon double bond, wherein the composition is free of a stabilizer; generating a plasma of the process gas; and depositing an amorphous carbon layer on the substrate.

According to another embodiment, the present invention provides a method for forming an amorphous carbon layer for use in integrated circuit fabrication. The amorphous carbon layer is formed by positioning the substrate in a processing chamber; introducing a process gas into the processing chamber, wherein the process gas comprises a composition comprising cyclopentene, wherein the composition is free of a stabilizer; generating a plasma of the process gas; and depositing an amorphous carbon layer on the substrate.

According to yet another embodiment, the present invention provides a method for forming an amorphous carbon layer on a substrate, the method comprising the steps of: positioning the substrate in a processing chamber; vaporizing liquid cyclopentene from a vessel to form at least one component of a process gas; introducing the process gas into the processing chamber; generating a plasma of the process gas; and depositing an amorphous carbon layer on the substrate.

An as-deposited amorphous carbon layer, deposited according to the process of the invention, has an adjustable carbon: hydrogen ratio that ranges from about 10% hydrogen to about 60% hydrogen. The amorphous carbon layer also has a light absorption coefficient, k, that can be varied between about 0.1 to about 1.0 at wavelengths below about 250 nm, making it suitable for use as an anti-reflective coating (ARC) at DUV wavelengths.

The amorphous carbon layer is compatible with integrated circuit fabrication processes. In one integrated circuit fabrication process, the amorphous carbon layer is used as a hardmask. For such an embodiment, a preferred process sequence includes depositing an amorphous carbon layer on a substrate. After the amorphous carbon layer is deposited on the substrate, an intermediate layer is formed thereon. A pattern is defined in the intermediate layer and transferred into the amorphous carbon layer. Thereafter, the pattern is transferred into the substrate using the amorphous carbon layer as a hardmask. Additionally, the pattern defined in the amorphous carbon hardmask can be incorporated into the structure of the integrated circuit, such as for example in a damascene structure.

The method of the present invention includes the step of positioning the substrate in a processing chamber. Suitable substrates upon which the amorphous carbon layer may be deposited according to the present invention include materials such as plastics; metals; various types of glass; magnetic heads; electronic chips; electronic circuit boards; semiconductor devices and the likes thereof. The substrate to be coated may be any shape or size provided that the substrate may be placed into the reaction chamber. Thus, regular or irregular shape objects having any dimension may be used in the present invention.

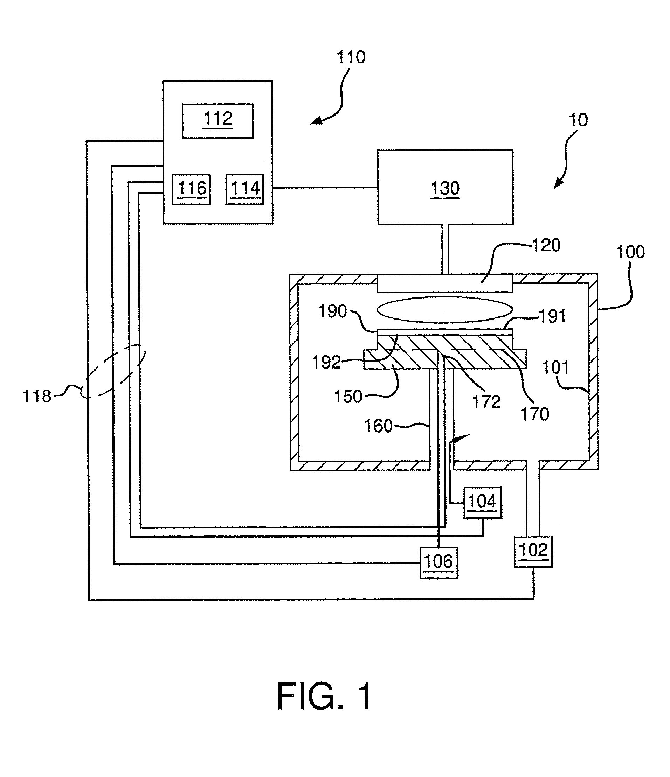

FIG. 1 is a schematic representation of a preferred wafer processing system **10** that can be used to perform amorphous carbon layer deposition in accordance with the present invention. This apparatus typically comprises a process chamber **100,** a gas panel **130,** a control unit **110,** along with other hardware components such as power supplies and vacuum pumps. Examples of such system include CENTURAO System's PRECISION 5000® systems and PRODUCER^{™} systems commercially available from Applied Materials Inc., Santa Clara, CA. Examples of other apparatus/ systems that can be employed in the present invention include Novellus' Vector System and ASM Japan's Dragon System, both of which are familiar to those of ordinary skill in the art.

Referring to FIG. 1, the process chamber **100** generally comprises a support pedestal **150,** which is used to support a substrate such as a semiconductor wafer **190.** This pedestal **150** can typically be moved in a vertical direction inside the chamber **100** using a displacement mechanism (not shown). Depending on the specific process, the wafer **190** can be heated to some desired temperature prior to processing. In the present invention, the wafer support pedestal **150** is heated by an embedded heater element **170**. For example, the pedestal **150** may be resistively heated by applying an electric current from an AC supply **106** to the heater element **170.** The wafer **190** is, in turn, heated by the pedestal **150.** A temperature sensor **172,** such as a thermocouple, is also embedded in the wafer support pedestal 150 to monitor the temperature of the pedestal **150** in a conventional manner. The measured temperature is used in a feedback loop to control the power supply **16** for the heating element **170** such that the wafer temperature can be maintained or controlled at a desired temperature which is suitable for the particular process application. The pedestal **150** is optionally heated using a plasma or by radiant heat (not shown).

A vacuum pump **102,** is used to evacuate the process chamber **100** and to maintain the proper gas flows and pressure inside the chamber **100.** A showerhead **120,** through which process gases are introduced into the chamber **100,** is located above the wafer support pedestal **150.** The showerhead **120** is connected to a gas panel **130,** which controls and supplies various gases used in different steps of the process sequence.

The showerhead **120** and wafer support pedestal **150** also form a pair of spaced apart electrodes. When an electric field is generated between these electrodes, the process gases introduced into the chamber **100** are ignited into a plasma. Typically, the electric field is generated by connecting the wafer support pedestal **150** to a source of radio frequency (RF) power (not shown) through a matching network (not shown). Alternatively, the RF power source and matching network may be coupled to the showerhead **120,** or coupled to both the showerhead **120** and the wafer support pedestal **150.**

Plasma enhanced chemical vapor deposition (PECVD) techniques promote excitation and/or disassociation of the reactant gases by the application of the electric field to the reaction zone near the substrate surface, creating a plasma of reactive species. The reactivity of the species in the plasma reduces the energy required for a chemical reaction to take place, in effect lowering the required temperature for such PECVD processes.

The method of the present invention also includes the steps of introducing a process gas into the processing chamber, wherein the process gas comprises, consists essentially of, or consists of a composition comprising, consisting essentially of, or consisting of a C₄ to C₁₀ cyclic hydrocarbon having a single carbon-carbon double bond; and generating a plasma of the process gas. Thus, according to the present invention, the amorphous carbon layer deposition is accomplished by plasma enhanced thermal decomposition of a process gas comprising a C₄ to C₁₀ cyclic hydrocarbon having a single carbon-carbon double bond.

In certain embodiments of the present invention, the composition comprising a C₄ to C₁₀ cyclic hydrocarbon having a single carbon-carbon double bond according to the present invention is free of a stabilizer such as, for example, a polymerization stabilizer. Unsaturated hydrocarbons that are typically prone to polymerization will typically degrade gradually or polymerize at ambient temperature or at moderate temperatures that are often encountered during normal processing, purification or application of the particular chemical. Chemicals that are typically employed to stabilize such hydrocarbons against polymerization such as, for example, phenols, amines, hydroxylamines, nitro compounds, quinine compounds, and substituted hydroquinone or hydroquinone-ether based compounds. The C₄ to C₁₀ cyclic hydrocarbons having a single carbon-carbon double bond according to the present invention are inherently stable and do not need a stabilizer. Hence, compositions of C₄ to C₁₀ cyclic hydrocarbons having a single carbon-carbon double bond for use in the process gas according to the present invention are free of a stabilizer.

In certain other embodiments of the present invention, the composition comprising a C₄ to C₁₀ cyclic hydrocarbon having a single carbon-carbon double bond may include a stabilizer. In such embodiments, the stabilizer may be included to stabilize impurities (i.e., compounds other than C₄ to C₁₀ cyclic hydrocarbon having a single carbon-carbon double bond) from polymerization or degradation. For example, in one embodiment of the present invention, the composition comprises cyclopentene having a small amount (e.g., from about 1 ppm to about 1.0 weight percent) of isoprene resulting from the production of the cyclopentene. In such cases, the isoprene impurity may polymerize (either during storage or in use) and clog the components of the CVD chamber such as, for example, delivery lines and injection ports. Accordingly, in such embodiments, from about 10 to about 10,000 parts per million (ppm) and, more preferably, from about 100 to about 500 ppm of a stabilizer such as, for example, one of the stabilizers listed above may be added to the composition. Specific examples of suitable stabilizers include butylated hydroxytoluene (BHT) and p-tert-butyl catechol (TBC).

Examples of a process gas comprising a C₄ to C₁₀ cyclic hydrocarbon having a single carbon-carbon double bond is a process gas comprising, for example, cyclobutene, cyclopentene, cyclohexene, cycloheptene, cyclooctene, cyclononene, cyclodecene, and mixtures thereof. In preferred embodiments of the present invention, the process gas comprises cyclopentene that is free of a stabilizer. For purposes of illustrating the present invention, cyclopentene will be referred to herein when referring to the C₄ to C₁₀ cyclic hydrocarbon having a single carbon-carbon double bond component of the process gas.

Compositions comprising a C₄ to C₁₀ cyclic hydrocarbon having a single carbon-carbon double bond and an impurity may be purified to remove the impurity by purification means known to those skilled in the art such as, for example, distillation, or adsorption using a solid resin, activated carbon or an activated alumina adsorbant such as, for example, CI 750 and CC710 from BASF/ Englehard (Iselin, New Jersey).

A vaporizer (not shown in FIG. 1) is typically employed to vaporize liquid cyclopentene monomer. Typical vaporizers have an inlet port for a liquid and an inlet port for an inert gas in an embodiment and comprise a mixing unit for mixing these gases and a unit for heating the mixture. The inert gas is typically introduced to the vaporizer from an inert gas flow-controller; and the liquid cyclopentene monomer is typically introduced into the vaporizer from a liquid monomer flow-controller. A heating temperature for the mixture is determined by a vapor pressure characteristic of the cyclopentene; in an embodiment, a temperature is kept in the range of about 25°C to about 75°C. Vaporized cyclopentene gas is typically introduced into the reactor through standard gas piping.

Alternatively, due to its relatively high vapor pressure (>300 Torr. at 21°C), cyclopentene can also be delivered to the chamber by direct vapor draw from the vessel through a mass flow controller.

In some embodiments, the process gas may also include an inert gas such as, for example, argon, helium, nitrogen, krypton, xenon, and neon. Inert gases may be used to control the density and deposition rate of the amorphous carbon layer. If employed, such inert gases would be present in the process gas at levels from about 50 to about 99% by volume. The inert gas, if employed, can be introduced into the reactor through the vaporizer or directly into the chamber from another port.

In some embodiments, the process gas may also include an oxidizing gas such as , for example, oxygen, N₂O, CO₂, and O₃. If employed, such oxidizing gases would be present in the process gas at levels from about 0.2 to about 30% by volume. The oxidizing gas, if employed, can be introduced into the reactor through the vaporizer or directly into the chamber from another port.

Additionally, other gases may be added to the process gas to modify properties of the amorphous carbon material. Hydrogen (H₂) may be added to the process gas to modify properties of the amorphous carbon material. Also, a nitrogen-containing gas such as, for example, nitrogen and/or ammonia may be added. The gases may be reactive gases such as, for example, hydrogen (H₂), ammonia (NH₃), a mixture of hydrogen (H₂) and nitrogen (N₂), fluorine based compounds (e.g., NF₃, F₂, CₓF_{y} fluorocarbons), or combinations thereof. The addition of H₂ and/or NH₃ can be used to control the hydrogen ratio of the amorphous carbon layer to control layer properties, such as reflectivity.

Preferably, the cyclopentene constitutes about 1 to about 99 percent by volume in the process gas. More preferably, the cyclopentene constitutes about 10 to about 50 percent by volume in the process gas.

Referring again to FIG. 1, the cyclopentene-containing process gas (also referred to herein as "the process gas") is introduced into the process chamber **100** under the control of gas panel **130.** The process gas is introduced into the process chamber as a gas with a regulated flow.

Proper control and regulation of the process gas flows through the gas panel 130 is performed by mass flow controllers (not shown) and a controller unit **110** such as a computer. The showerhead **120** allows process gases from the gas panel **130** to be uniformly distributed and introduced into the process chamber **100.** Illustratively, the control unit **110** comprises a central processing unit (CPU) **112,** support circuitry **114,** and memories containing associated control software **116.** This control unit **110** is responsible for automated control of the numerous steps required for wafer processingsuch as wafer transport, gas flow control, temperature control, chamber evacuation, and so on. Bi-directional communications between the control unit **110** and the various components of the apparatus **10** are handled through numerous signal cables collectively referred to as signal buses **118,** some of which are illustrated in FIG. 1.

The heated pedestal **150** used in the present invention is typically made of aluminum, and comprises a heating element **170** embedded at a distance below the wafer support surface **151** of the pedestal **150.** The heating element **170** can be made of a nickel-chromium wire encapsulated in a sheath tube. By properly adjusting the current supplied to the heating element **170,** the wafer **190** and the pedestal **150** can be maintained at a relatively constant temperature during film deposition. This is accomplished by a feedback control loop, in which the temperature of the pedestal **150** is continuously monitored by a thermocouple **172** embedded in the pedestal **150.** This information is transmitted to the control unit **110** via a signal bus **118,** which responds by sending the necessary signals to the heater power supply. Adjustment is subsequently made in the current supply **106** so as to maintain and control the pedestal **150** at a desirable temperature, *i*.*e*., a temperature that is appropriate for the specific process application. When the process gas mixture exits the showerhead **120,** plasma enhanced thermal decomposition of the hydrocarbon compound occurs at the surface **191** of the heated wafer **190,** resulting in a deposition of an amorphous carbon layer on the wafer **190.**

In general, the following deposition process parameters can be used to form the amorphous carbon layer. The process parameters range from a wafer temperature of about 100°C to about 500°C, a chamber pressure of about 1 torr to about 20 torr, a cyclopentene gas flow rate of about 50 sccm to about 500 sccm (per 8 inch wafer), a RF power of between about 3 W/in² to about 20 W/in², and a plate spacing of between about 300 mils to about 600 mils. The above process parameters provide a typical deposition rate for the amorphous carbon layer in the range of about 100 Å/min to about 1000 Å/min and can be implemented on a 200 mm substrate in a deposition chamber.

Other deposition chambers are within the scope of the invention and the parameters listed above may vary according to the particular deposition chamber used to form the amorphous carbon layer. For example, other deposition chambers comprising different energy sources such as, for example, a hot filament, dual frequency PECVD, high density plasma, and ECR source may be used according to the present invention.

The as-deposited amorphous carbon layer has an adjustable carbon: hydrogen ratio that ranges from about 10% hydrogen to about 60% hydrogen. Controlling the hydrogen ratio of the amorphous carbon layer is desirable for tuning its optical properties as well as its etch selectivity. Specifically, as the hydrogen ratio decreases the optical properties of the as-deposited layer such as for example, the index of refraction (n) and the absorption coefficient (k) increase. Similarly, as the hydrogen ratio decreases the etch resistance of the amorphous carbon layer increases.

The light absorption coefficient, k, of the amorphous carbon layer can be varied between about 0.1 to about 1.0 at wavelengths below about 250 nm, making it suitable for use as an anti-reflective coating (ARC) at DUV wavelengths. The absorption coefficient of the amorphous carbon layer can be varied as a function of the deposition temperature. In particular, as the temperature increases the absorption coefficient of the as-deposited layer likewise increases.

The following examples are given to illustrate the scope of the present invention. Because these examples are given for illustrative purposes only, the invention embodied therein should not be limited thereto.

### EXAMPLES

Plasma-enhanced chemical vapor deposition ("PECVD") of carbon films were performed on a Gaseous Electronics Conference ("GEC") reactor at a pressure of 100 mTorr and 10 W plasma power at a temperature between 400 and 550°C. The gas flows were 5 sccm argon and 5 sccm hydrocarbon precursor. Films with physical properties similar to those deposited in the GEC reactor could also be achieved by depositing the films in a 200 mm Applied Materials lamp heated DxL chamber attached to a P-5000 platform. Etch rate data was obtained by etching the films in a CF₄ based RIE plasma in the GEC reactor using the following conditions: 55 sccm CF₄, 55 sccm He, 35 mTorr, 300 W.

Table 1 shows the deposition characteristics as well as physical properties of films deposited from isoprene and cyclopentene. These films were deposited under identical conditions. The cyclopentene films exhibit increased deposition rate as well as a higher refractive index which is indicative of a more highly cross-linked film. The molar absorptivity (K) as measured at a wavelength of 240 nm are nearly equivalent. The etch rate is lower for the films deposited from cyclopentene, indicating enhanced performance as an etch stop layer. The density as measured by small angle X-Ray reflectivity is higher for the films deposited from cyclopentene, indicating better etch stop performance.

**Table 1**

| **Precursor** | **Precursor H/C Ratio** | **Dep Rate (nm/min)** | **RI** | **K(abs @ 240 nm)** | **Etch Rate (nm/min)** | **Density g/cc** |
|---|---|---|---|---|---|---|
| **Isoprene** | **1.6** | **40.6** | **1.66** | **0.14** | **82.1** | **1.21** |
| **Cyclopentene** | **1.6** | **46.1** | **1.72** | **0.17** | **70.3** | **1.26** |

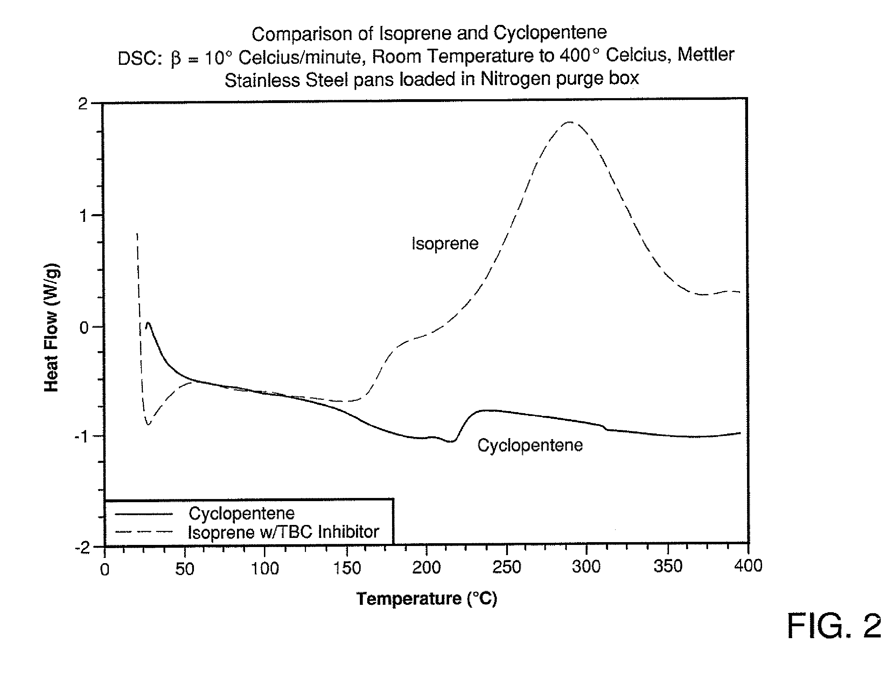

FIG. 2 compares the thermal stability of isoprene and cyclopentene as measured by differential scanning calorimetry ("DSC"). These samples were sealed in a stainless steel pan and placed in a DSC instrument to measure the thermal stability and heat evolved from the sample. The upper curve is the DSC data obtained from isoprene. It is clear from this data that the isoprene begins to exothermically decompose above ∼175°C with a large exotherm above ∼250°C, the energy evolved in the second step is significant and clearly indicates a safety risk if the material is exposed to elevated temperatures. The lower curve was obtained under identical conditions for cyclopentene, there is no exothermic reaction below 225°C and the amount of energy released at higher temperatures is significantly less than that measured for isoprene.

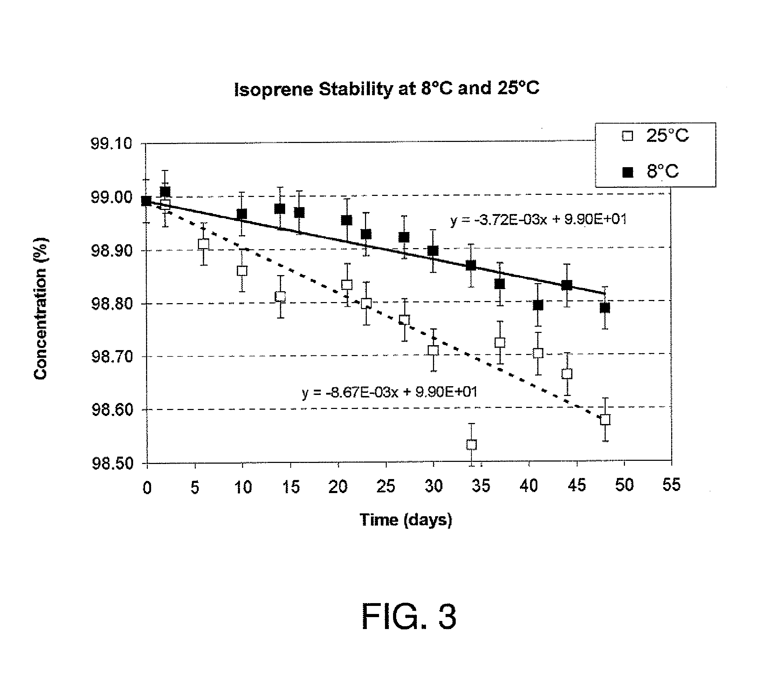

FIG. 3 shows the change in isoprene purity with time at 8 and 25°C. This data indicates that there is a decrease in isoprene purity over a matter of days at 28°C. This is due to the dimerization of the isoprene which is a 4+2 Diels-Alder dimerization of a conjugated diene. We have also shown that addition of an inhibitor will not effect the rate of dimerization. This decrease in purity over time will hinder it's usefulness as a precursor for the microelectronics industry which needs high purity chemicals that have relatively long shelf-lives, typically on the order of 1 year or greater. Isoprene could be stored in a refrigerated area, however, that would significantly increase the cost and logistics for using this precursor.

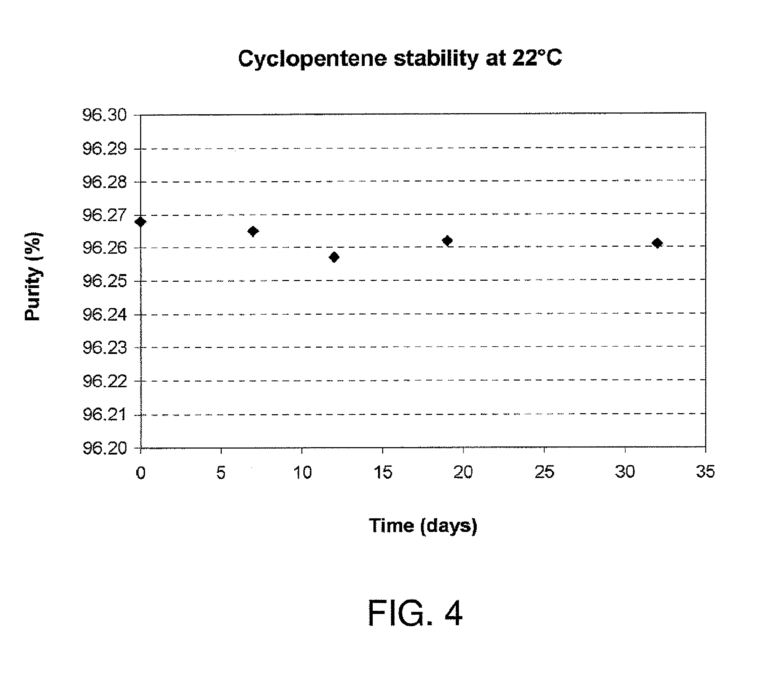

FIG. 4 shows the purity over time for cyclopentene at 22°C over a period of 32 days. Cyclopentene is much more stable than isoprene since the former material contains no conjugated diene, and as such, has no direct mechanism for dimerization. Therefore, there is essentially no change in the purity of the cyclopentene observed over time. Cyclopentene is expected to have a useable shelf-life of at least one year, making it a more viable candidate for use as a precursor in the microelectronics industry than other more reactive materials such as isoprene or similar chemicals that contain conjugated dienes. The invention further relates to the following items
1. A method for forming an amorphous carbon layer on a substrate, the method comprising the steps of:
   positioning the substrate in a processing chamber;
   introducing a process gas into the processing chamber, wherein the process gas comprises a composition comprising cyclopentene, wherein the composition is free of a stabilizer;
   generating a plasma of the process gas; and
   depositing an amorphous carbon layer on the substrate.
2. The method of Item 1 wherein the process gas further comprises an inert gas.
3. The method of Item 1 wherein the process gas further comprises a nitrogen-containing gas.
4. The method of Item 3 wherein the nitrogen-containing gas comprises nitrogen or ammonia.
5. The method of Item 1 wherein the process gas further comprises hydrogen gas.
6. The method of Item 1 wherein the process gas further comprises an oxidizing gas.
7. The method of Item 1 wherein the process gas further comprises fluorine gas.
8. A method for forming an amorphous carbon layer on a substrate, the method comprising the steps of:
   positioning the substrate in a processing chamber;
   vaporizing liquid cyclopentene from a vessel to form at least one component of a process gas;
   introducing the process gas into the processing chamber;
   generating a plasma of the process gas; and
   depositing an amorphous carbon layer on the substrate.
9. The method of Item 8 wherein the process gas further comprises an inert gas.
10. The method of Item 8 wherein the process gas further comprises a nitrogen-containing gas.
11. The method of Item 10 wherein the nitrogen-containing gas comprises nitrogen or ammonia.
12. The method of Item 8 wherein the process gas further comprises hydrogen gas.
13. The method of Item 8 wherein the process gas further comprises an oxidizing gas.
14. The method of Item 8 wherein the process gas further comprises fluorine gas.
15. A method for forming an amorphous carbon layer on a substrate, the method comprising the steps of:
   positioning the substrate in a processing chamber;
   introducing a process gas into the processing chamber, wherein the process gas comprises a composition comprising a C₄ to C₁₀ cyclic hydrocarbon having a single carbon-carbon double bond, wherein the composition is free of a stabilizer;
   generating a plasma of the process gas; and
   depositing an amorphous carbon layer on the substrate.
16. The method of Item 15 wherein the C₄ to C₁₀ cyclic hydrocarbon is selected from the group consisting of: cyclobutene, cyclopentene, cyclohexene, cycloheptene, cyclooctene, cyclononene, cyclodecene, and mixtures thereof.
17. The method of Item 16 wherein the C₄ to C₁₀ cyclic hydrocarbon is cyclopentene.

## Claims

1. A method for forming an amorphous carbon layer on a substrate, the method comprising the steps of:
positioning the substrate in a processing chamber;
introducing a process gas into the processing chamber, wherein the process gas comprises a composition comprising a C₄ to C₁₀ cyclic hydrocarbon having a single carbon-carbon double bond, wherein the composition is free of a stabilizer;
generating a plasma of the process gas; and
depositing an amorphous carbon layer on the substrate.

2. The method of Claim 1 wherein the C₄ to C₁₀ cyclic hydrocarbon is selected from the group consisting of: cyclobutene, cyclopentene, cyclohexene, cycloheptene, cyclooctene, cyclononene, cyclodecene, and mixtures thereof.

3. The method of Claims 1 to 2 wherein the C₄ to C₁₀ cyclic hydrocarbon is cyclopentene.

4. The method of any of Claims 1 to 3, further comprising the step of vaporizing liquid C₄ to C₁₀ cyclic hydrocarbon from a vessel to form at least one component of a process gas.

5. The method of any of Claims 1 to 4 wherein the process gas further comprises an inert gas.

6. The method of any of Claims 1 to 5 wherein the process gas further comprises a nitrogen-containing gas.

7. The method of any of Claims 1 to 6 wherein the nitrogen-containing gas comprises nitrogen or ammonia.

8. The method of any of Claims 1 to 7 wherein the process gas further comprises hydrogen gas.

9. The method of any of Claim 1 to 8 wherein the process gas further comprises an oxidizing gas.

10. The method of any of Claims 1 to 9 wherein the process gas further comprises fluorine gas.
